# EUROPEAN PATENT APPLICATION

(11) **EP 3 633 317 A2**
(43) Date of publication of application: **08.04.2020**
(21) Application number: 19191607.1
(22) Date of filing: 13.08.2019
(51) Int. Cl.: G01C 19/66, H01S 3/06, H01S 3/07, H01S 3/083, H01S 3/094, H01S 3/0941, H01S 3/16, H01S 3/17

(54) **SYSTEMS AND METHODS FOR END PUMPED LASER MIRROR STACK ASSEMBLIES**

(30) Priority: 17.08.2018 US 201816104773
(71) Applicant: Honeywell International Inc., Morris Plains, NJ New Jersey 07950 (US)
(72) Inventor: MARTA, Teresa, Morris Plains, New Jersey 07950 (US); VRIEZE, Lance, Morris Plains, New Jersey 07950 (US); TOUCHBERRY, Alan Bruce, Morris Plains, New Jersey 07950 (US)
(74) Representative: Houghton, Mark Phillip

(57) **Abstract**

Systems and methods for end pumped laser mirror stack assemblies are provided. In one embodiment, an end pump mirror stack assembly for a laser resonator comprises: a pump light injection layer applied to a transparent substrate, the pump light injection layer comprising at least one light generating optical emitter embedded within the pump light injection layer, wherein the pump light injection layer is configured to transmit a pump light having a first wavelength into the substrate; a multilayer thin-film mirror stack coupled to the transparent substrate; a lasing material layer coupled transparent substrate and positioned to receive the pump light, wherein the lasing material layer is doped with a dopant that generates a fluorescent light output at a second frequency when exposed to the pump light; and an antireflective coating applied to the substrate, the first anti-reflective coating configured to pass light of the first wavelength.

## Description

### BACKGROUND

Laser gyroscopes have traditionally included a laser block that comprises a ring shaped laser cavity filled with a gas lasing medium. High voltage anodes and cathodes in the laser block are energized to ionize the gas, and light generated by discharging of the gas is reflected around the ring shaped cavity by mirrors to generate a laser beam. However, such laser gyroscopes can suffer due to degradation of the gas lasing medium, and also require high voltage electronics and related infrastructure. Solid state lasers have been developed using Neodymium (Nd), which is one type of solid state LASER material that has desirable fluorescing properties, and may be doped with other materials to obtain other desired characteristics. Early Nd laser systems were typically pumped using tungsten filament lamps, and for that reason, the reliability of such lasers was an issue due to short lamp life as well as other reasons, such as the light not being well aligned with the axis of the laser beam path within the laser block.

For the reasons stated above and for other reasons stated below which will become apparent to those skilled in the art upon reading and understanding the specification, there is a need in the art for systems and methods for end pumped laser mirror stack assemblies.

### SUMMARY

The Embodiments of the present disclosure provide methods and systems for systems and methods for end pumped laser mirror stack assemblies and will be understood by reading and studying the following specification.

Systems and methods for end pumped laser mirror stack assemblies are provided. in one embodiment, an end pump mirror stack assembly for a laser resonator comprises: a pump light injection layer applied to a first surface of a transparent substrate, the pump light injection layer comprising at least one light generating optical emitter embedded within the pump light injection layer, wherein the pump light injection layer is configured to transmit a pump light having a first wavelength into the first surface of substrate; a multilayer thin-film mirror stack coupled to a second surface of the transparent substrate; a lasing material layer coupled to the second surface of the transparent substrate and positioned to receive the pump light, wherein the lasing material layer is doped with a dopant that generates a fluorescent light output at a second frequency when exposed to the pump light from the pump light injection layer; and an antireflective coating applied to the substrate, the first anti-reflective coating configured to pass light of the first wavelength.

### DRAWINGS

Embodiments of the present disclosure can be more easily understood and further advantages and uses thereof more readily apparent, when considered in view of the description of the preferred embodiments and the following figures in which:
Figure 1 is a diagram illustrating a mirror stack end pumped laser gyroscope of one embodiment of the present disclosure;
Figure 2 is a block diagram illustrating an end pumped laser mirror stack assembly of one embodiment of the present disclosure;
Figure 3 is a block diagram illustrating an end pumped laser mirror stack assembly of one embodiment of the present disclosure;
Figure 4 is a block diagram illustrating an end pumped laser mirror stack assembly of one embodiment of the present disclosure; and
Figure 5 is a block diagram illustrating an end pumped laser mirror stack assembly of one embodiment of the present disclosure.

In accordance with common practice, the various described features are not drawn to scale but are drawn to emphasize features relevant to the present disclosure. Reference characters denote like elements throughout figures and text.

### DETAILED DESCRIPTION

In the following detailed description, reference is made to the accompanying drawings that form a part hereof, and in which is shown by way of specific illustrative embodiments in which the embodiments may be practiced. These embodiments are described in sufficient detail to enable those skilled in the art to practice the embodiments, and it is to be understood that other embodiments may be utilized and that logical, mechanical and electrical changes may be made without departing from the scope of the present disclosure. The following detailed description is, therefore, not to be taken in a limiting sense.

Embodiments of the present disclosure provide systems and methods for end pumped laser mirror stack assemblies for use with closed path/ring laser gyroscope and other applications. As described in greater detail below, these embodiments employ stacking of a pump light source, mirror, substrates, mirror coatings, thin film lasing medium, and other materials, etc. into a single integrated stack. Such embodiments provide for direct optical pumping of the lasing medium) or another layer within the structure. The fluorescence generated by the optically pumped lasing medium could be located and aligned within the lasing path of a laser block assembly, with an efficient overlap with the optical path to achieve benefits over existing laser gyroscopes.

Optical emitters, such as light emitting diodes (LEDs), diode lasers, vertical-cavity surface-emitting laser, (VCSEL) lasers, edge mitting lasers, light-emitting coatings, as well as optional diffractive optical elements, may be integrated into the structure of the laser mirror stack for the purposed of pumping of the solid state laser materials, such as but not limited to Nd thin film material.

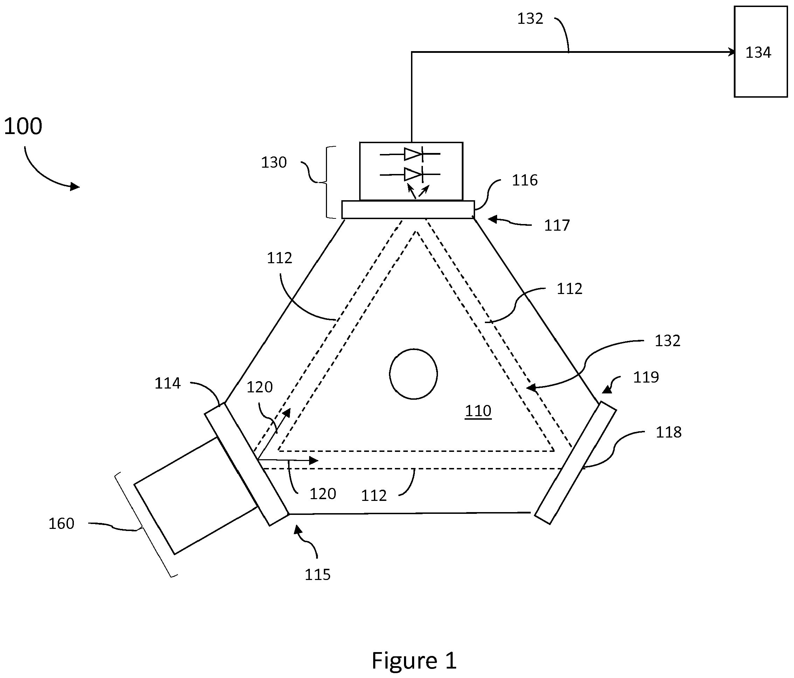

Figure 1 is a simplified block diagram illustrating a mirror stack end pumped laser gyroscope 100 of one embodiment of the present disclosure. Gyroscope 100 includes a ring laser gyroscope a laser block sensor 110 in which in which interior cavity ring 112 is formed. It should be understood that the term "ring" as used herein refers to a closed path that encloses an area and is not limited to circular closed paths. Mirror assemblies 114, 116 and 118 are provided at corners 115, 117 and 119. In conjunction with the mirrors 115, 117 and 119, interior cavity ring 112 forms a laser beam path enclosing an area within the laser block sensor 110. The interior cavity ring 112 may be empty (for example, at some level of vacuum) or filled with an inert gas. In this embodiment, light beams 120 of a specific wavelength are created in the interior cavity ring 112 by mirror assembly 114, which comprises an end pumped laser mirror stack assembly 160 described in greater detail below.

In the embodiment of Figure 1, laser block sensor 110 is triangular in shape having three sides and three blunted corners. It should be understood that this is provided as a nonlimiting example, as other embodiment may comprising a laser block sensor 110 formed using a different shape laser block sensor.

One or more light beams 120 created in the interior cavity ring 112 are repeatedly reflected around the interior cavity ring 112 by the mirror assemblies 114, 116 and 118 (either in the clockwise (CW) direction, counterclockwise (CCW) direction, or both) supporting gain to create lasing of the light beams 120 into laser light. In one embodiment, one of the other mirror assemblies (such as mirror assembly 116, for example) is used as a read-out device 130. The interior cavity ring 112 and the mirror assemblies 114, 116 and 118 thus form a closed laser resonator path. Is should be appreciated that in alternative implementations of the embodiments described herein, as opposed to the laser block sensor 110 comprising an interior resonator cavity that defines a ring path for the light beams 120 to follow, the interior resonator cavity of laser block sensor 110 may instead comprise a linear resonator.

The performance of ring laser gyroscope 100 is observed by coupling optical energy information from the interior cavity ring 112 to the read-out device 130 The readout device 130 inputs the optical energy and as a function of that optical energy provides an output of one or more voltage signals 132 to one or more processing elements 134. In some embodiments, the readout device 130 may comprise photodetectors. For example in some embodiments, differences in frequencies between counter-rotating laser beams within the interior cavity ring 112 may be determined from the voltage signals 132, and hence rotation information may be obtained. In addition to the rotation information, the readout device 130 may also provide a voltage signal correlated with laser intensity.

One of ordinary skill in the art after reading this specification would appreciate that Figure 1 illustrates a simplified block diagram that provides sufficient detail to facilitate an enabled written description of embodiments of the present invention. Additional details not shown regarding the physical structure and electronic circuitry associated with a laser block sensor for a ring laser gyroscope are considered within the knowledge and skill of one of ordinary skill in the art and are therefore not discussed herein.

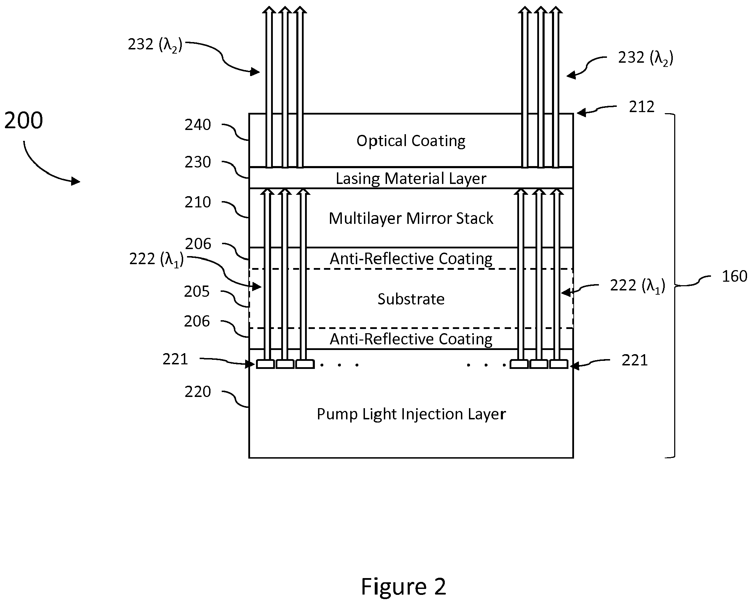

Figure 2 is a block diagram illustrating an end pumped laser mirror stack assembly 200, which may be used as the end pumped laser mirror stack assembly 160 in conjunction with mirror stack end pumped laser gyroscope 100, or used for other applications.

End pumped laser mirror stack assembly 200 comprises a multilayer thin-film mirror stack 210 deposited on a transparent substrate 205, a pump light injection layer 220 applied to the transparent substrate 205, and a fluorescing lasing material layer 230 (which may be applied to the multilayer thin-film mirror stack 210 or otherwise secured to the substrate 205). As discussed above, the path of a laser block sensor interior resonator cavity may be defined by the highly reflective multi-layer dielectric stacks (i.e., reflective at λ2) shown as mirror assemblies 114, 116 and 118 in Figure 1. For embodiments where assembly 200 is used in conjunction with such an interior resonator cavity, the multilayer thin-film mirror stack 210 shown in Figures 2- 5 may serve the function of the mirror assembly 114.

Pump light injection layer 220 is configured to transmit a beam of light of a first wavelength, λ₁, (shown in Figure 2 as pump light 222) into a first surface of the substrate 205. Transparent substrate 205 is transparent in the sense that it passes light at least in a range of wavelengths that includes λ₁, through to the opposing second surface of substrate 205. In one embodiment, one or both surfaces of the transparent substrate 205 are coated with an anti-reflective coating 206 having optical characteristics that include very low reflectance at wavelengths of λ₁. As the term is used herein, an anti-reflective coating is a coating that has a reflectance of less than 1% for a specified wavelength. Anti-reflective coating(s) 206 thus may be included to reduce optical power loss due to reflections of pump light 222 at the surfaces of substrate 205.

In some embodiments, pump light 222 is generated by one or more light generating optical emitters 221 embedded within the pump light injection layer 220. In alternate implementations, the optical emitters 221 may comprise one or more light emitting diodes (LEDs), an array of LEDs, one or more lasers or array of lasers such as vertical-cavity surface-emitting laser (VCSEL) lasers, edge emitting lasers, or one or more light-emitting coatings. In some embodiments, the pump light injection layer 220 may comprise an embedded or integrated multi-chip module with components on a carrier that is integrated within the pump light injection layer 220.

In operation, pump light 222 of wavelength λ₁ is generated within the pump light injection layer 220 and directed to the lasing material layer 230. The lasing material layer 230 is doped with a dopant (for example, lasing material layer 230 may comprise a layer of Nd-doped silica) that generates a fluorescent light 232 at a second frequency, λ₂, when exposed to the pump light 222 of wavelength λ₁. For example, in one embodiment the pump light 222 generated by the pump light injection layer 220 has a wavelength λ₁ of approximately 803nm, which causes an Nd doped lasing material layer 230 to fluoresce an output of florescent light 232 having a wavelength λ₂ of approximately 1050-1065nm. The end pumped laser mirror stack assembly 200 outputs the fluorescent light 232 through its output end 212, which may be directed, for example, into the interior cavity ring 112 of the mirror stack end pumped laser gyroscope 100.

In one embodiment, the multilayer thin-film mirror stack 210 has a surface reflectivity that is highly reflective to any incoming light entering from output end 212 having a wavelength λ₂. As the term is used herein, a surface or coating that is highly reflective has a reflectance of at least 99% for a specified wavelength. For example, in one embodiment, multilayer thin-film mirror stack 210 may comprises a dielectric mirror of alternating coatings of thin film dielectric layers having different refractivity characteristics that are selected to produce the highly reflective surface to light of wavelength λ₂. Moreover, the refractivity characteristics of the dielectric layers may be tuned to optimize the reflectivity of light received at angle of incidence that would correspond to light expected to be received from the interior cavity ring 112. In contrast, the multilayer thin-film mirror stack 210 may at the same time be highly transmissive to light of wavelength λ₁ so that the pump light 222 will pass through the multilayer thin-film mirror stack 210 to reach the lasing material layer 230 with little loss.

As shown in Figure 2, the stack 200 includes an additional optical coating 240 applied to the output side of lasing material layer 230 that may be anti-reflective to light of wavelength λ₂, highly-reflective to light of wavelength λ₁, or both.

With respect to wavelength λ₁, reflection of any pump light 222 emerging from lasing material layer 230 back into the lasing material layer 230 enables multi passes of the pump light 222 through the lasing material which increases efficiency by permitting additional fluorescent light 232 to be produced from the pump light 222 already generated by pump light injection layer 220. With respect to wavelength λ₂, having an optical coating layer with anti-reflective characteristics for light of wavelength λ₂ reduce loss of efficiency caused by fluorescent light 232 failing to exit the end pumped laser mirror stack assembly 200 at output end 212, and also prevents losses due to scattering by ensuring that any laser light at λ₂ received in from output end 212 passes completely to the multilayer thin-film mirror stack 210 before being reflected.

As such, when the end pumped laser mirror stack assembly 200 is used in conjunction with mirror stack end pumped laser gyroscope 100, light of wavelength λ₂ is created in the interior cavity ring 112, traverses around interior cavity ring 112, and then is received back from interior cavity ring 112, and is reflected by the multilayer thin-film mirror stack 210 back into the interior cavity ring 112 with high efficiency, thus resulting in a high Q-factor (10^8 or greater) laser block 110.

Because the pump light injection layer 220 is a rigidly integrated component of the end pumped laser mirror stack assembly 200, the fluorescent light 232 can exit from the end pumped laser mirror stack assembly 200 in alignment with the laser beam path defined within the interior cavity ring 112. That is, in some embodiments, the pump light injection layer 220 aligns the pump light 222 to produce fluorescent light 232 from the lasing material layer 230 that is aligned with the axis (that is, the plane) of the laser beam paths defined within the interior cavity ring 112.

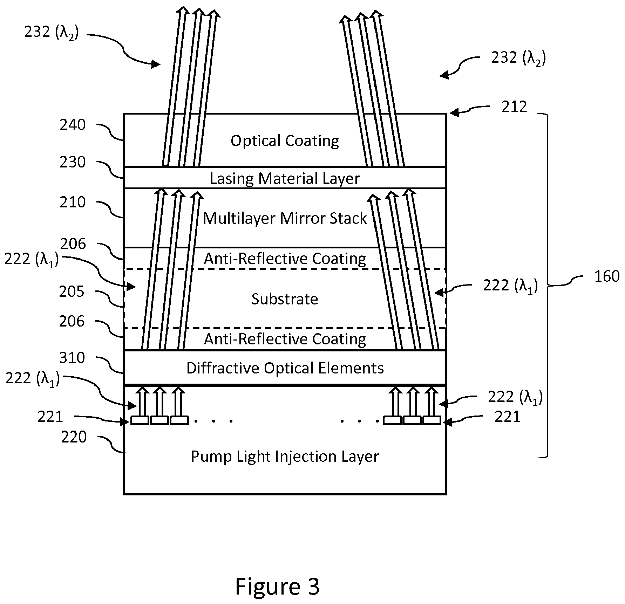

Figure 3 is a diagram illustrating an alternate implementation of the end pumped laser mirror stack assembly 200 shown in Figure 2, where the pump light injection layer 220 may include or be further coupled to a layer of optional diffractive optical elements 310. Redirection of the pump light 222 by the diffractive optical elements 310 may be used to control the alignment of fluorescent light 232 generated by lasing material layer 230, for example, to align the fluorescent light 232 output with the laser beam path of interior cavity ring 112, direct the fluorescent light 232 to travel in the CW or CCW directions around the interior cavity ring 112, or split the fluorescent light 232 output so that one portion of the fluorescent light 232 is directed to travel in the CW direction around the interior cavity ring 112 and a second portion of the fluorescent light 232 is directed to travel in the CCW direction around the interior cavity ring 112. In some embodiments, pump light 222 from selected emitters 221 may be specifically directed to produce fluorescent light 232 having differing alignments from others.

Although Nd doped silica has been discussed above as an example lasing material for the lasing material layer 230, it should be understood that this material is mentioned for example purposes only, and that other solid or thin film lasing materials (for example, other rare-earth materials) may be used instead in silica, titania, or other glassy hosts (such as but not limited to oxide glasses, fluoride glasses, fluorosilicate glasses) for any of the embodiments described herein. It should also be understood that although the lasing material layer 230 is illustrated as a distinct layer, in other embodiments, lasing materials may be included, for example, within layers of the mirror stack or substrate 105,

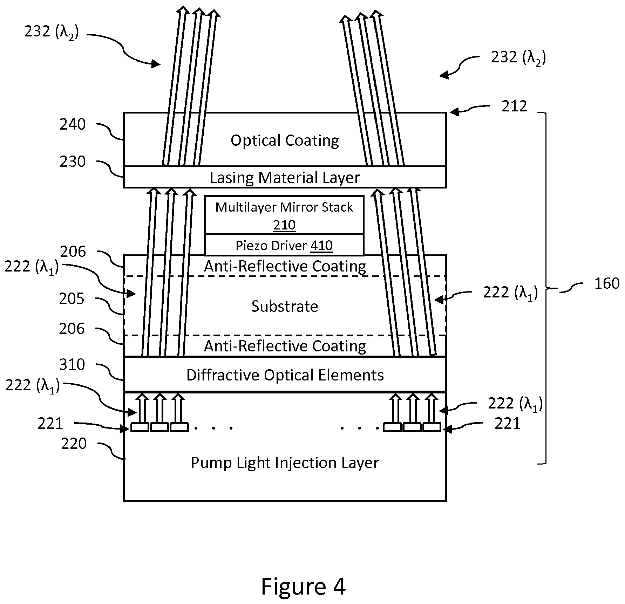

Figure 4 is a diagram illustrating another alternate implementation of the end pumped laser mirror stack assembly 200 shown in Figure 2, where the pump light injection layer 220 may further include a piezoelectric driver 410 (or motor) positioned between the multilayer thin-film mirror stack 210 and substrate 205 such that the multilayer thin-film mirror stack 210 is coupled to the substrate 205 via the piezoelectric driver 410. In operation, piezoelectric driver 410 mechanically dithers (i.e. oscillates) the multilayer thin-film mirror stack 210. For example, when used in conjunction with a ring laser gyroscope a laser block sensor 110 as shown in Figure 1, dithering of the multilayer thin-film mirror stack 210 may be used to suppress dead band errors which can occur at low rotation rates. In the embodiment shown in Figure 4, the pump light 222 may be directed to avoid traversing through the multilayer thin-film mirror stack 210 in its path to lasing material layer 230. In some embodiments, the multilayer thin-film mirror stack 210 is shaped and/or sized so that pump light 222 can be directed to the lasing material layer 230 while avoiding the multilayer thin-film mirror stack 210. In some embodiments, the pump light 222 can be directed to the lasing via a waveguide and/or waveguide layers.

For example, in Figure 4, the multilayer thin-film mirror stack 210 has a smaller diameter as compared to the array of optical emitters 221 in the pump light injection layer 220. Further as shown in Figure 4, the optional optical elements 310 may be used to also (or instead) diffract the pump light 222 so as to bypass the multilayer thin-film mirror stack 210. By directing pump light 222 to avoid passing through a dithering multilayer thin-film mirror stack 210, such an embodiment can increase the optical power of pump light 222 reaching lasing material layers 230. Additionally, such an embodiment provides optical separation such that the newly generated fluorescent light 232 output remains aligned to the laser beam path of the interior cavity ring 112, while separately providing for a dithering induced modulation of laser light travelling around interior cavity ring 112.

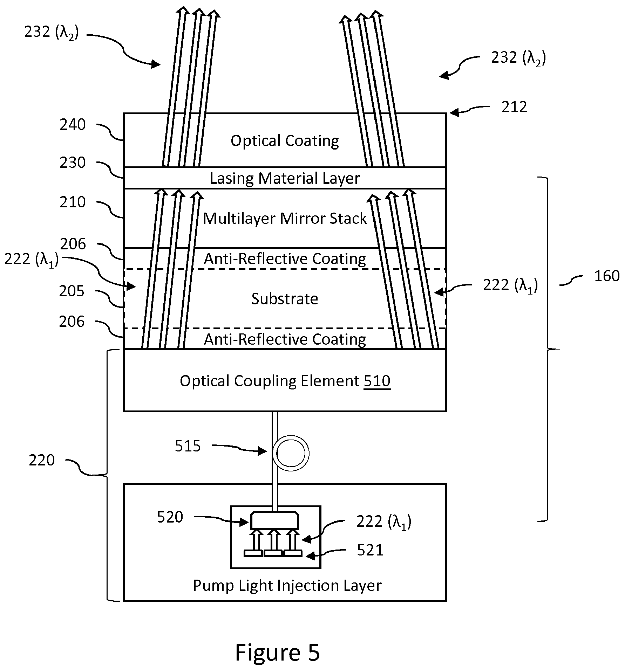

Figure 5 is a diagram illustrating another alternate implementation of the end pumped laser mirror stack assembly 500. End pumped laser mirror stack assembly 500 functions in the same manner as the various embodiments and implementations of pump light injection layer 220 shown in Figures 2-4, however, the pump light injection layer 220 comprises one or more remotely located optical emitters 521 that generates the pump light 222, and the pump light 222 is transmitted to the substrate 205 via a fiber optic medium 515 and optical coupling element 510. In some embodiments, pump light 222 from the one or more remotely located optical emitters 521 is coupled onto the fiber optic medium 515 by a fiber interface 520. In some embodiments, the fiber interface 520 may comprise an optical combiner that combines the pump light 222 from each of the optical emitters 521 onto either a single fiber optic medium 515, or a multi-fiber optic medium 515. In some embodiments, the optical coupling element 510 may comprise a flat-end gradient-index optics lens (such as a, SELFOC Microlens, for example) or other diffractive optical elements (such as the Diffractive Optical Elements 310 described above) that couple the pump light 222 from the fiber optic medium 515 into the substrate 205 with the desired beam alignment(s).

### EXAMPLE EMBODIMENTS

Example 1 includes an end pump mirror stack assembly for a laser resonator, the assembly comprising: a pump light injection layer applied to a first surface of a transparent substrate, the pump light injection layer comprising at least one light generating optical emitter embedded within the pump light injection layer, wherein the pump light injection layer is configured to transmit a pump light having a first wavelength into the first surface of substrate; a multilayer thin-film mirror stack coupled to a second surface of the transparent substrate; a lasing material layer coupled to the second surface of the transparent substrate and positioned to receive the pump light, wherein the lasing material layer is doped with a dopant that generates a fluorescent light output at a second frequency when exposed to the pump light from the pump light injection layer; and an antireflective coating applied to the substrate, the first anti-reflective coating configured to pass light of the first wavelength.
Example 2 include the assembly of example 1, further comprising: an optical coating applied to the lasing material layer, the optical coating configured to be anti-reflective to light of the second wavelength, and highly-reflective to light of the first wavelength.
Example 3 include the assembly of any of examples 1-2, wherein the lasing material layer comprises a Neodymium doped thin film.
Example 4 include the assembly of any of examples 1-3, wherein the at least one light generating optical emitter comprises at least one of: a light emitting diode (LED), an array of LEDs, a vertical-cavity surface-emitting laser (VCSEL) laser; an edge emitting lasers, or a light-emitting coating.
Example 5 include the assembly of any of examples 1-4, wherein the pump light injection layer is coupled to the transparent substrate via a diffractive optical element layer.
Example 6 include the assembly of any of examples 1-5, wherein the pump light from the at least one light generating optical emitter is coupled into the first surface of the transparent substrate via a fiber optic medium.
Example 7 include the assembly of example 6, wherein the pump light injection layer comprises an optical coupling element, wherein the pump light is coupled from the fiber optic medium into the transparent substrate via the optical coupling element.
Example 8 include the assembly of any of examples 1-7, wherein the pump light injection layer is a rigidly integrated component of the end pumped laser mirror stack assembly.
Example 9 include the assembly of any of examples 1-8, further comprising a piezoelectric driver, wherein the multilayer thin-film mirror stack is coupled to the substrate via the piezoelectric driver, and the piezoelectric driver is configured to mechanically oscillate the multilayer thin-film mirror stack.
Example 10 include the assembly of any of example 9, wherein the pump light is directed to bypass the thin-film mirror stack.
Example 11 include the assembly of any of example 9-10, wherein the multilayer thin-film mirror stack is inset such that at least a portion of the pump light from the pump light injection layer is applied to the lasing material layer without passing through the multilayer thin-film mirror stack.
Example 12 includes a mirror stack end pumped laser gyroscope, the gyroscope comprising: a laser block assembly having an interior resonator cavity therein; a readout device optically coupled to the laser block assembly that outputs one or more voltage signals; an end pumped laser mirror stack assembly coupled to the laser block assembly, wherein the end pumped laser mirror stack assembly creates one or more light beams in the interior resonator cavity; wherein the end pumped laser mirror stack assembly comprises: a pump light injection layer applied to a first surface of a transparent substrate, the pump light injection layer comprising at least one light generating optical emitter embedded within the pump light injection layer, wherein the pump light injection layer is configured to transmit a pump light having a first wavelength into the first surface of substrate; a multilayer thin-film mirror stack coupled to a second surface of the transparent substrate; a lasing material layer coupled to the second surface of the transparent substrate and positioned to receive the pump light, wherein the lasing material layer is doped with a dopant that generates a fluorescent light output at a second frequency when exposed to the pump light from the pump light injection layer, wherein the one or more light beams comprises the fluorescent light output; an antireflective coating applied to the substrate, the first anti-reflective coating configured to pass light of the first wavelength; an optical coating applied to the lasing material layer, the optical coating configured to be anti-reflective to light of the second wavelength, and highly-reflective to light of the first wavelength.
Example 13 include the gyroscope of example 12, wherein interior resonator cavity of the laser block assembly comprises an interior cavity ring therein that defines a closed path laser beam path around the laser block assembly; and wherein the end pump mirror stack assembly is configured to direct a first portion of the fluorescent light output in a clockwise direction through the interior cavity ring, and a portion of the fluorescent light output in a counter-clockwise direction through the interior cavity ring.
Example 14 include the gyroscope of any of examples 12-13, wherein interior resonator cavity of the laser block assembly comprises an interior cavity ring therein that defines a closed path laser beam path around the laser block assembly; wherein the fluorescent light output is injected into the laser block assembly aligned with an axis of the closed path laser beam path of the interior cavity ring.
Example 15 include the gyroscope of any of examples 12-14, further comprising: an optical coating applied to the lasing material layer, the optical coating configured to be anti-reflective to light of the second wavelength, and highly-reflective to light of the first wavelength.
Example 16 include the gyroscope of any of examples 12-15, wherein the lasing material layer comprises a Neodymium doped thin film.
Example 17 include the gyroscope of any of examples 12-16, wherein the at least one light generating optical emitter comprises at least one of: a light emitting diode (LED), an array of LEDs, a vertical-cavity surface-emitting laser (VCSEL) laser, an edge emitting lasers, or a light-emitting coating.
Example 18 include the gyroscope of any of examples 12-17, wherein the pump light injection layer is coupled to the transparent substrate via a diffractive optical element layer.
Example 19 include the gyroscope of any of examples 12-18, further comprising a piezoelectric driver, wherein the multilayer thin-film mirror stack is coupled to the substrate via the piezoelectric driver, and the piezoelectric driver is configured to mechanically oscillate the multilayer thin-film mirror stack.
Example 20 include the assembly of example 19, wherein the pump light does not pass through the thin-film mirror stack.

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the presented embodiments. Therefore, it is manifestly intended that embodiments be limited only by the claims and the equivalents thereof.

## Claims

1. An end pump mirror stack assembly (116, 200) for a laser resonator, the assembly (116, 200) comprising:
a pump light injection layer (220) applied to a first surface of a transparent substrate (205), the pump light injection layer (220) comprising at least one light generating optical emitter (221) embedded within the pump light injection layer (220), wherein the pump light injection layer (220) is configured to transmit a pump light (222) having a first wavelength into the first surface of substrate (205);
a multilayer thin-film mirror stack (210) coupled to a second surface of the transparent substrate (205);
a lasing material layer (230) coupled to the second surface of the transparent substrate (205) and positioned to receive the pump light (222), wherein the lasing material layer (230) is doped with a dopant that generates a fluorescent light output at a second frequency when exposed to the pump light (222) from the pump light injection layer (220);
an antireflective coating (206) applied to the substrate (205), the antireflective coating (206) configured to pass light of the first wavelength.

2. The assembly (116, 200) of claim 1, further comprising:
an optical coating (240) applied to the lasing material layer (230), the optical coating (240) configured to be anti-reflective to light of the second wavelength, and highly-reflective to light of the first wavelength.

3. The assembly (116, 200) of claim 1, wherein the pump light injection layer (220) is coupled to the transparent substrate (205) via a diffractive optical element layer (310).

4. The assembly (116, 200) of claim 1, wherein the pump light injection layer (220) is a rigidly integrated component of the end pumped laser mirror stack assembly (116, 200).

5. The assembly (116, 200) of claim 1 further comprising a piezoelectric driver (410), wherein the multilayer thin-film mirror stack (210) is coupled to the substrate (205) via the piezoelectric driver (410), and the piezoelectric driver is configured to mechanically oscillate the multilayer thin-film mirror stack (210).

6. The assembly (116, 200) of claim 5, wherein the multilayer thin-film mirror stack (210) is inset such that at least a portion of the pump light (222)from the pump light injection layer (220) is applied to the lasing material layer (230) without passing through the multilayer thin-film mirror stack (210).

7. A mirror stack end pumped laser gyroscope (100), the gyroscope comprising:
a laser block assembly (110) having an interior resonator cavity (112) therein;
a readout device (130) optically coupled to the laser block assembly (110) that outputs one or more voltage signals (132);
an end pumped laser mirror stack assembly (116, 200) coupled to the laser block assembly (110), wherein the end pumped laser mirror stack assembly (116, 200) creates one or more light beams in the interior resonator cavity (112);
wherein the end pumped laser mirror stack assembly (116, 200) comprises:
a pump light injection layer (220) applied to a first surface of a transparent substrate (205), the pump light injection layer (220) comprising at least one light generating optical emitter (221) embedded within the pump light injection layer (220), wherein the pump light injection layer (220) is configured to transmit a pump light (222) having a first wavelength into the first surface of substrate (205);
a multilayer thin-film mirror stack (210) coupled to a second surface of the transparent substrate (205);
a lasing material layer (230) coupled to the second surface of the transparent substrate (205) and positioned to receive the pump light, wherein the lasing material layer (230) is doped with a dopant that generates a fluorescent light output at a second frequency when exposed to the pump light (222) from the pump light injection layer (220), wherein the one or more light beams comprises the fluorescent light output;
an antireflective coating (206) applied to the substrate (205), the first anti-reflective coating configured to pass light of the first wavelength;
an optical coating (240) applied to the lasing material layer (230), the optical coating (240) configured to be anti-reflective to light of the second wavelength, and highly-reflective to light of the first wavelength.

8. The gyroscope (100) of claim 7, further comprising:
an optical coating (240) applied to the lasing material layer (230), the optical coating (240) configured to be anti-reflective to light of the second wavelength, and highly-reflective to light of the first wavelength.

9. The assembly (116, 200) of claim 1 or the gyroscope (100) of claim 7, wherein the lasing material layer (230) comprises a Neodymium doped thin film.

10. The gyroscope of claim 7, further comprising a piezoelectric driver, wherein the multilayer thin-film mirror stack (210) is coupled to the substrate (205) via the piezoelectric driver, and the piezoelectric driver is configured to mechanically oscillate the multilayer thin-film mirror stack (210); and
wherein the pump light (222) does not pass through the thin-film mirror stack (210).
